# EUROPEAN PATENT SPECIFICATION

(11) **EP 3 562 265 B1**
(45) Date of publication and mention of the grant of the patent: **13.04.2022**
(21) Application number: 18169887.9
(22) Date of filing: 27.04.2018
(51) Int. Cl.: H05B 6/06, F24C 7/08, H01H 36/00, H03K 17/97

(54) **DOMESTIC APPLIANCE ADAPTED FOR STAND-BY MODE**
FÜR BEREITSCHAFTSBETRIEB ANGEPASSTES HAUSHALTSGERÄT
APPAREIL MÉNAGER CONÇU POUR UN MODE VEILLE

(43) Date of publication of application: 30.10.2019
(73) Proprietor: ELECTROLUX APPLIANCES AKTIEBOLAG, 105 45 Stockholm (SE)
(72) Inventor: BALEST, Frederico, 47122 Forli (IT); VIROLI, Alex, 47122 Forli (IT); MARTINI, Filippo, 47100 Forli (IT); CHRISTIANSEN, Svend Erik, 47100 Forli (IT); SCOTTO D'APOLLONIA, Adriano, 47122 Forli (IT); JEANNETEAU, Laurent, 47122 Forli (IT)
(74) Representative: Electrolux Group Patents

(56) References cited:
- EP-A1- 0 497 191
- EP-A1- 0 600 780
- DE-A1-102006 007 169
- GB-A- 2 067 033
- US-A- 5 920 131

## Description

The present invention relates to a domestic appliance adapted for stand-by mode. In particular, the present invention relates to a cooking hob adapted for stand-by mode. Preferably, the present invention relates to an induction cooking hob adapted for stand-by mode.

A domestic appliance adapted for stand-by mode allows that said domestic appliance is activatable and deactivatable in a simple way. In particular, such a domestic appliance is activatable and deactivatable by a remote control. However, the domestic appliance consumes energy during the stand-by mode. This unneeded energy consumption impairs the economy of the domestic appliance.

US 5,920,131 A discloses an arrangement for the control of electrically controllable appliances, particularly electric cooking hobs, comprising operating elements, which are magnetically held in contactless manner on the top of a plate, e. g. a glass ceramics plate. A magnet below the plate magnetically secures the operating element, which can be rotated in contactless manner. A latching relay is provided for enabling the appliance to be supplied with power by the mains voltage. If all operating elements are in off-condition, the latching relay opens and the appliance is disconnected from the mains voltage.

From EP 0 497 191 A1 a method for controlling a cooking hob and a related control device is known. A power control for a heating zone of the cooking hob comprises a sliding element, which includes a magnetic element and is mechanically guided on a top plate of the cooking hob. Reed switches are arranged in a in a row below said top plate. The magnetic element of the sliding element magnetically activates a respective reed switch of the row related to the actual position of the sliding element. At an end position, the reed switch row comprises reed switches for controlling an electromechanical unit for switching on and off the mains supply.

A sliding control element comprising a magnetic element for power control of a heating zone of an induction cooking hob is also known from UK 2 067 033 A. The sliding control element is movably disposed along a groove in the top plate surface. Below the top plate a magnetic field adjusting plate is arranged in the area of the groove. Close to the end of the magnetic field adjusting plate, a magnetic field detecting circuit including a Hall element is arranged providing information of the position of the sliding control element to a control circuit for power controlling. In an off-position of the sliding control element, the magnetic element deactivates a reed switch resulting in a disconnection of the induction cooking hob from the mains voltage.

EP 0 600 780 A1 illustrates a cooking oven comprising an operating knob for power control of a heating element. The operating knob is rotatable around a pin projecting outwardly of a glass panel of the cooking oven and comprises a small permanent magnet displaced from the axis of rotation of the operating knob. The permanent magnet acts upon one of a number of reed relays, which are arranged behind the glass panel on a circumference equidistantly from each other. Each reed relay corresponds to a power level for operating the heating element.

DE 10 2006 007 169 A1 discloses an example of an electrical equipment operating device.

It is an object of the present invention to provide a domestic appliance adapted for stand-by mode, wherein said domestic appliance does not consume any energy during the stand-by mode.

The object is achieved by the domestic appliance adapted for stand-by mode according to claim 1.

Preferred embodiments may be taken from the dependent claims, and, beyond that, from the following description, in particular comprising various embodiments as covered and described in the annexed claims.

According to the present invention a domestic appliance adapted for stand-by mode is provided, wherein:
- the domestic appliance comprises at least one main switch being switchable between an open state and a closed state, the domestic appliance further comprising a relay supply control, at least one rectifier, and at least one reed switch,
- the main switch includes at least one high-voltage input and at least one high-voltage output,
- the high-voltage input of the main switch is connectable to a mains line,
- the high-voltage output of the main switch is connected to the at least one rectifier,
- the high-voltage input and the high-voltage output are galvanically disconnected from each other in the open state of the main switch,
- the high-voltage input and the high-voltage output are galvanically connected to each other in the closed state of the main switch,
- the main switch is controllable by at least one control device electrically isolated from the domestic appliance the main switch is a relay,
- a control input of the main switch is connected to the relay supply control, the relay supply control being responsive to the at least one reed switch, the at least one reed switch being responsive to a magnetic field generated by the control device,
- the at least one reed switch is a secondary switch for controlling the main switch, and
- the rectifier is adapted for generating at least one high-voltage and for generating at least one low voltage.

The present invention provides that the domestic appliance further comprises at least one capacitor, wherein the at least one capacitor is loadable during a standard operation of the domestic appliance, and wherein the energy stored in said capacitor is adapted for supplying the relay supply control.

The core of the present invention is the galvanic separation between the domestic appliance with the main switch on the one hand and the control device on the other hand, wherein the control device switches and controls the main switch. The electrical isolation between the main switch and the control device prevents current flow during the stand-by mode, so that the domestic appliance does not consume any electric energy during the stand-by mode. In addition, the relay allows a reliable galvanic disconnection.

For example, the control device is an integrated part of the domestic appliance and/or an external part corresponding with the domestic appliance.

In particular, said low voltage is provided for at least one low voltage supply.

According to an embodiment, the low voltage supply is connected to an input of the at least one reed switch.

An output of the at least one reed switch may be connected to the relay supply control.

The control device may be a magnetic element movable between at least one on-position and at least one off-position, wherein the reed switch is in a closed state, if the magnetic element is in the on-position, while said reed switch is in an open state, if the magnetic element is in the off-position.

Further, the domestic appliance may be a cooking hob, wherein the reed switch is arranged beneath a cooking panel, while the magnetic element is arranged above said cooking panel.

In particular, the domestic appliance is an induction cooking hob, wherein the high-voltage appliance is an induction coil.

For example, the magnetic element is linearly moveable on a guiding plate between the on-position and the off-position.

Alternatively, the control device includes a rotatable disk, wherein at least one magnetic element is arranged at or embedded within said a disk, and wherein the magnetic element is moveable between the on-position and the off-position by rotating said disk. Preferably, the disk is a circular disk.

For example, the rotatable disk is a rotary dial.

Further, the rotatable disk or the rotary dial, respectively, may be detachable from the domestic appliance. Preferably, said rotatable disk or rotary dial provides a child-proof lock.

Novel and inventive features of the present invention are set forth in the appended claims.

The present invention will be described in further detail with reference to the drawings, in which
- FIG 1: illustrates a schematic circuit diagram of a domestic appliance according to a preferred embodiment of the present invention,
- FIG 2: illustrates a schematic sectional side view of a reed switch according to a first embodiment of the present invention,
- FIG 3: illustrates a schematic sectional side view of the reed switch according to a second embodiment of the present invention, and
- FIG 4: illustrates a schematic sectional top view of the reed switch according to the second embodiment of the present invention.

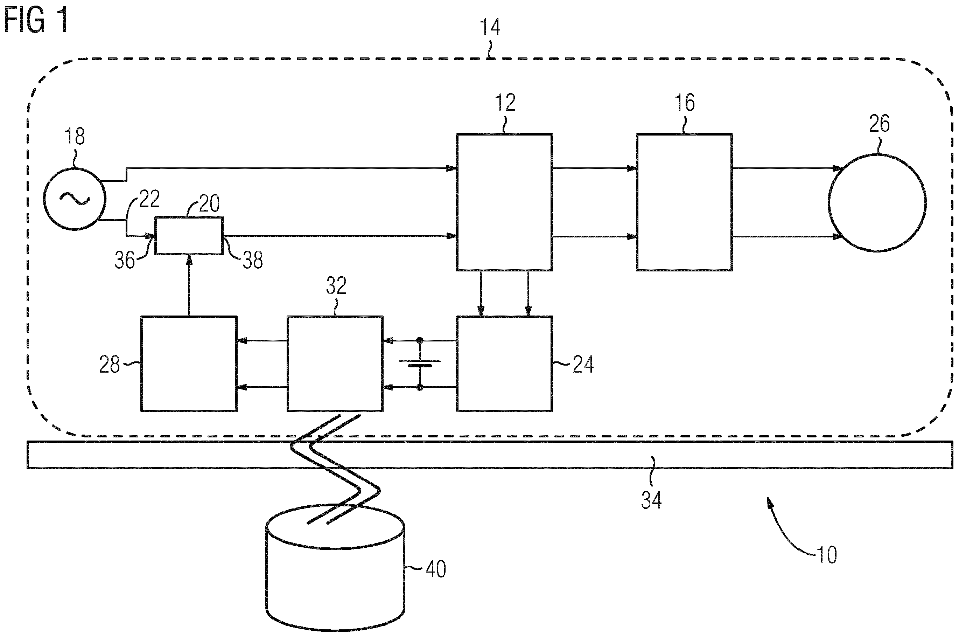

FIG 1 illustrates a schematic circuit diagram of a domestic appliance 10 according to a preferred embodiment of the present invention. In this example, the domestic appliance 10 is an induction cooking hob.

The domestic appliance 10 comprises a control board block 14 including a rectifier 12, a power generator 16, a power supply 18, a main switch 20, a mains line 22, a low voltage supply 24, a reed switch 32, a relay supply control 28 and an induction coil 26. For example, the main switch 20 is a relay and includes a high-voltage input 36 and a high-voltage output 38. The high-voltage input 36 of the switch 20 is connected to the mains line 22. The high-voltage output 38 of the switch 20 is connected to a high-voltage input of the rectifier 12. A high-voltage output of said rectifier 12 is connected to an input of the power generator 16. In turn, an output of the power generator 16 is connected to the induction coil 26. A low-voltage output of the rectifier 12 is connected to an input of the low voltage supply 24. A low-voltage output of said low voltage supply 24 is connected to an input of the reed switch 32. The reed switch 32 is connected to the relay supply control 28.

The control board block 14 is arranged beneath a cooking panel 34 of the induction cooking hob. A magnetic element 40 is arranged above said cooking panel 34. The reed switch 32 corresponds with the moveable magnetic element 40. The magnetic element 40 is movable between an on-position and an off-position by a user. In the on-position, the magnetic element 40 is arranged directly above the reed switch 32. In the off-position, the magnetic element 40 is spaced from the reed switch 32.

The main switch 20 connects the domestic appliance 10 to the mains line 22. The main switch 20 is open, when the domestic appliance 10 is in a stand-by mode, so that the domestic appliance 10 is electrically isolated from the mains line 22. When the main switch 20 is closed, then the rectifier 12 is connected to the mains line 22. The power generator 16 drives the induction coil 26, while the low voltage supply 24 generates at least one low voltage, e.g. 5 V and/or 12 V, for the reed switch 32.

When the domestic appliance 10 is in a stand-by mode, then the main switch 20 and the reed switch 32 are open. The domestic appliance 10 leaves the stand-by mode, if the magnetic element 40 is in the on-position, wherein the reed switch 32 is in a closed state. When the reed switch 32 is in the closed state, then the relay supply control 28 can be activated and the main switch 20 is closed.

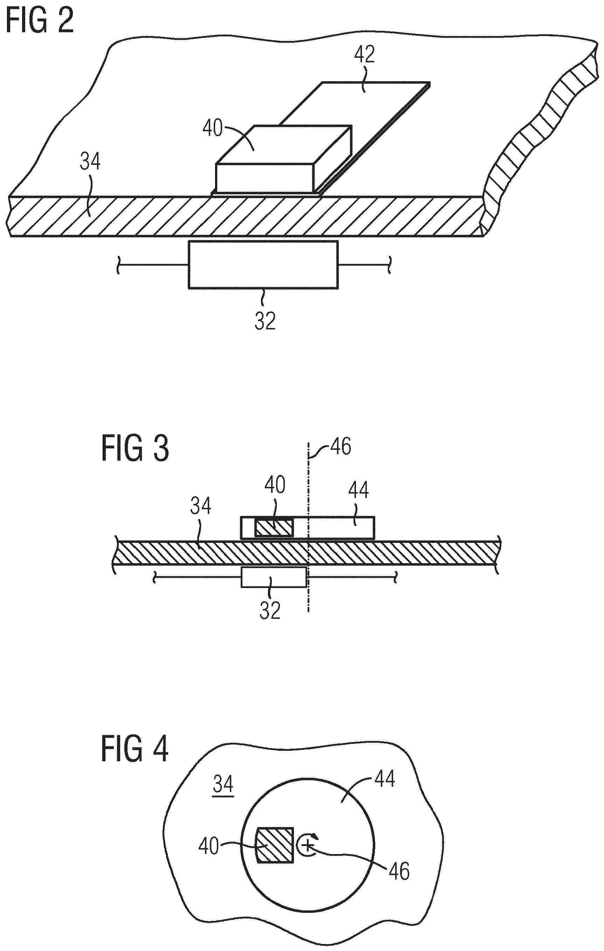

FIG 2 illustrates a schematic sectional side view of the reed switch 32 according to a first embodiment of the present invention.

The proper reed switch 32 is arranged at the lower surface of the dielectric panel 34. Further, the reed switch 32 corresponds with the magnetic element 40 attached movably on the guiding plate 42. Said guiding plate 42 is arranged on the upper surface of the dielectric panel 34. In this embodiment, the magnetic element 40 is linearly movable on the guiding plate 42 between the on-position and the off-position by the user. The on-position and the off-position correspond with two opposite stops of the guiding plate 42. In the on-position the magnetic element 40 is arranged directly above the reed switch 32, while said magnetic element 40 is spaced from the reed switch 32 in the off-position.

FIG 3 illustrates a schematic sectional side view of the reed switch according to a second embodiment of the present invention.

The proper reed switch 32 of the second embodiment is also arranged at the lower surface of the dielectric panel 34. The reed switch 32 corresponds with the magnetic element 40 embedded within a rotatable disk 44. Alternatively, the magnetic element 40 may be arranged above or beneath the rotatable disk 44. Said disk 44 is rotatable around a rotation axis 46 extending perpendicular to the plane of the disk 44. In this embodiment, the disk is a circular disk 44. In general, the disk 44 may have an arbitrary shape.

The circular disk 44 is rotatably arranged on the upper surface of the dielectric panel 34. In this example, the rotation axis 46 corresponds with the symmetry axis of the rotation-symmetric disk 44. Alternatively, the rotation axis 46 may differ from the symmetry axis, so that the disk 44 acts as an eccentric disk. In this embodiment, the magnetic element 40 is movable along a circular path when the circular disk 44 is rotated by the user. The on-position and the off-position correspond with two turning positions of the circular disk 44. Said turning positions differ in a rotation of 180 degrees of the circular disk 44. In the on-position the magnetic element 40 is arranged directly above the reed switch 32, while said magnetic element 40 is spaced from the reed switch 32 in the off-position.

FIG 4 illustrates a schematic sectional top view of the reed switch 32 according to the second embodiment of the present invention. FIG 4 clarifies the arrangement of the magnetic element 40 within the rotatable disk 44.

The circular disk 44 is rotatably arranged on the upper surface of the dielectric panel 34. In this example, the rotation axis 46 corresponds with the symmetry axis of the rotation-symmetric circular disk 44. The on-position and the off-position differ in a rotation of 180 degrees of the circular disk 44.

For example, the rotatable disk 44 is formed as a rotary dial.

In the examples of FIG 2 to 4, the reed switch 32 is a part of a cooking hob with a dielectric panel 34, e.g. a glass ceramic panel.

When the magnetic element 40 is in the on-position, then internal contact elements of the reed switch 32 are connected to each other. In contrast, when the magnetic element 40 is in the off-position, then internal contact elements of the reed switch 32 are disconnected from each other.

The reed switch 32 of the first and second embodiments may be used for the domestic appliance 10 shown in FIG 1 in a way, that the switch 20 and the auxiliary power supply 24 are replaced by said reed switch 32. In this case, a high-voltage input 36 of the reed switch 32 would be connected to the mains line 22, while a high voltage output 38 of said reed switch 32 would be connected to the high-voltage input of the power electronic 16 and to the high-voltage input of the power supply 18. Further, the function of the auxiliary power supply 24 is taken over by the magnetic element 40, which controls the reed switch 32.

When the user switches off the reed switch 32 by moving the magnetic element into the off-position, then the reed switch 32 is opened and the domestic appliance 10 does not consume any power.

According to a further embodiment of the present invention the domestic appliance 10 comprises an activating device in order to activate said domestic appliance 10. Said activating device includes an external circuit and an internal circuit. If the domestic appliance 10 is a cooking hob, then said passive receiving circuit is preferably arranged beneath the panel 34. The passive receiving circuit is connected to the control input of the switch 20 in order to close said switch 20 and activate the domestic appliance 10, after the corresponding external circuit has been sent a suitable signal.

According to the second embodiment of the present invention the domestic appliance 10 comprises the rotary dial 44 including at least one magnetic element 40 arranged at or embedded within the disk 44. If the domestic appliance 10 is a cooking hob, then said rotary dial 44 is preferably arranged above the panel 34, while receiving elements are arranged beneath said panel 34. For example, the receiving elements are one or more coils, wherein the current induced in said coil controls the switch 20. The switch 20 may be a relay, a triac or an SCR thyristor, wherein preferably the power supply 18 is arranged beside said switch 20. Additionally, the rotary dial 44 may be provided for setting the user interface 12. In order to obtain a child-proof lock, the rotary dial may be detachable. Moreover, the rotary dial with magnetic element 40 may be used in the second embodiment instead of the guiding plate 42 and the linearly movable magnetic element 40.

According to the present invention a large capacitor is used, wherein said capacitor is loaded during the normal operation of the domestic appliance 10. The energy stored in the capacitor may be supplied to the relay supply control.

The embodiments in the figures may relate to preferred embodiments, while all elements and features described in connection with embodiments may be used, as far as appropriate, in combination with any other embodiment and feature as discussed herein, in particular related to any other embodiment discussed further above.

The features of the present invention disclosed in the specification, the claims, examples and/or the figures may both separately and in any combination thereof be material for realizing the invention in various forms thereof.

### List of reference numerals

- 10: domestic appliance
- 12: rectifier
- 14: control board block
- 16: power generator
- 18: power supply
- 20: main switch
- 22: mains line
- 24: low voltage supply
- 26: induction coil
- 28: relay supply control
- 32: reed switch
- 34: cooking panel, dielectric panel
- 36: high-voltage input
- 38: high-voltage output
- 40: magnetic element
- 42: guiding plate
- 44: circular disk
- 46: rotation axis

## Claims

1. A domestic appliance (10) adapted for stand-by mode, wherein:
- the domestic appliance (10) comprises at least one main switch (20) being switchable between an open state and a closed state, the domestic appliance further comprising a relay supply control (28), at least one rectifier (12), and at least one reed switch (32),
- the main switch (20) includes at least one high-voltage input and at least one high-voltage output,
- the high-voltage input (36) of the main switch (20) is connectable to a mains line (22),
- the high-voltage output of the main switch (20) is connected to the at least one rectifier (12),
- the high-voltage input and the high-voltage output are galvanically disconnected from each other in the open state of the main switch (20),
- the high-voltage input and the high-voltage output are galvanically connected to each other in the closed state of the main switch (20),
- the main switch (20) is controllable by at least one control device (40, 42) electrically isolated from the domestic appliance (10),
- the main switch is a relay (20),
- a control input of the main switch (20) is connected to the relay supply control (28), the relay supply control (28) being responsive to the at least one reed switch (32), the at least one reed switch (32) being responsive to a magnetic field generated by the control device (40, 42), and
- the at least one reed switch (32) is a secondary switch for controlling the main switch (20),
- the rectifier (12) is adapted for generating at least one high-voltage and for generating at least one low voltage,
**characterised in that** the domestic appliance further comprises at least one capacitor, wherein the at least one capacitor is loadable during a standard operation of the domestic appliance (10), and wherein the energy stored in said capacitor is adapted for supplying the relay supply control (28) .

2. The domestic appliance according to claim 1,
**characterised in that**
the control device (28, 30; 40, 42) is an integrated part of the domestic appliance (10) and/or an external part (40) corresponding with the domestic appliance (10).

3. The domestic appliance according to claim 1 or 2, **characterised in that**
said low voltage is provided for at least one low voltage supply (24).

4. The domestic appliance according to claim 3,
**characterised in that**
the low voltage supply (24) is connected to an input of the at least one reed switch (32).

5. The domestic appliance according to claim 4,
**characterised in that**
an output of the at least one reed switch (32) is connected to the relay supply control (28).

6. The domestic appliance according to any one of the preceding claims,
**characterised in that**
the control device is a magnetic element (40) movable between at least one on-position and at least one off-position, wherein the reed switch (32) is in a closed state, if the magnetic element (40) is in the on-position, while said reed switch (32) is in an open state, if the magnetic element (40) is in the off-position.

7. The domestic appliance according to claim 6,
**characterised in that**
the domestic appliance (10) is a cooking hob, wherein the reed switch (32) is arranged beneath a cooking panel (34), while the magnetic element (40) is arranged above said cooking panel (34), wherein preferably the domestic appliance (10) is an induction cooking hob and the rectifier (12) is connected to a power generator (16), which in turns drives an induction coil (26).

8. The domestic appliance according to claim 6 or 7,
**characterised in that**
the magnetic element (40) is linearly moveable on a guiding plate (42) between the on-position and the off-position.

9. The domestic appliance according to claim 6 or 7,
**characterised in that**
the control device includes a rotatable disk (44), wherein at least one magnetic element (40) is arranged at or embedded within said disk (44), and wherein the magnetic element (40) is moveable between the on-position and the off-position by rotating said disk (44), and wherein preferably the disk is a circular disk (44).

10. The domestic appliance according to claim 9, **characterised in that**
the rotatable disk (44) is a rotary dial.

11. The domestic appliance according to claim 9 or 10, **characterised in that**
the rotatable disk (44) is detachable from the domestic appliance (10) and/or the rotatable disk (44) provides a child-proof lock.

## Patentansprüche

1. Haushaltsgerät (10), das für eine Stand-by-Betriebsart ausgelegt ist, wobei:
- das Haushaltsgerät (10) wenigstens einen Hauptschalter (20) umfasst, der zwischen einem geöffneten Zustand und einem geschlossenen Zustand geschaltet werden kann, wobei das Haushaltsgerät ferner eine Relais-Versorgungssteuerung (28), wenigstens einen Gleichrichter (12) und wenigstens einen Reed-Schalter (32) umfasst,
- der Hauptschalter (20) wenigstens einen Hochspannungseingang und wenigstens einen Hochspannungsausgang aufweist,
- der Hochspannungseingang (36) des Hauptschalters (20) mit einer Netzleitung (22) verbunden werden kann,
- der Hochspannungsausgang des Hauptschalters (20) mit dem wenigstens einen Gleichrichter (12) verbunden ist,
- der Hochspannungseingang und der Hochspannungsausgang im geöffneten Zustand des Hauptschalters (20) voneinander galvanisch getrennt sind,
- der Hochspannungseingang und der Hochspannungsausgang im geschlossenen Zustand des Hauptschalters (20) miteinander galvanisch verbunden sind,
- der Hauptschalter (20) durch wenigstens eine Steuervorrichtung (40, 42) gesteuert werden kann, die vom Haushaltsgerät (10) elektrisch isoliert ist,
- der Hauptschalter ein Relais ist (20),
- ein Steuereingang des Hauptschalters (20) mit der Relais-Versorgungssteuerung (28) verbunden ist, wobei die Relais-Versorgungsteuerung (28) auf den wenigstens einen Reed-Schalter (32) anspricht, wobei der wenigstens eine Reed-Schalter (32) auf ein Magnetfeld anspricht, das durch die Steuervorrichtung (40, 42) erzeugt wird, und
- der wenigstens eine Reed-Schalter (32) ein Zweitschalter zum Steuern des Hauptschalters (20) ist,
- der Gleichrichter (12) ausgelegt ist, wenigstens eine Hochspannung zu erzeugen und wenigstens eine Niederspannung zu erzeugen,
**dadurch gekennzeichnet, dass** das Haushaltsgerät ferner wenigstens einen Kondensator umfasst, wobei der wenigstens eine Kondensator während eines Standardbetriebs des Haushaltsgeräts (10) geladen werden kann und wobei die Energie, die im Kondensator gespeichert ist, die Relais-Versorgungssteuerung (28) versorgen kann.

2. Haushaltsgerät nach Anspruch 1,
**dadurch gekennzeichnet, dass**
die Steuervorrichtung (28, 30; 40, 42) ein integriertes Element des Haushaltsgeräts (10) und/oder ein externes Element (40) entsprechend dem Haushaltsgerät (10) ist.

3. Haushaltsgerät nach Anspruch 1 oder 2,
**dadurch gekennzeichnet, dass**
die Niederspannung für wenigstens eine Niederspannungsquelle (24) bereitgestellt wird.

4. Haushaltsgerät nach Anspruch 3,
**dadurch gekennzeichnet, dass**
die Niederspannungsquelle (24) mit einem Eingang des wenigstens einen Reed-Schalters (32) verbunden ist.

5. Haushaltsgerät nach Anspruch 4,
**dadurch gekennzeichnet, dass**
ein Ausgang des wenigstens einen Reed-Schalters (32) mit der Relais-Versorgungssteuerung (28) verbunden ist.

6. Haushaltsgerät nach einem der vorhergehenden Ansprüche,
**dadurch gekennzeichnet, dass**
die Steuervorrichtung ein magnetisches Element (40) ist, das zwischen wenigstens einer Ein-Position und wenigstens einer Aus-Position bewegt werden kann, wobei der Reed-Schalter (32) in einem geschlossenen Zustand ist, wenn das magnetische Element (40) in der Ein-Position ist, wohingegen der Reed-Schalter (32) in einem offenen Zustand ist, wenn das magnetische Element (40) in der Aus-Position ist.

7. Haushaltsgerät nach Anspruch 6,
**dadurch gekennzeichnet, dass**
das Haushaltsgerät (10) ein Kochfeld ist, wobei der Reed-Schalter (32) unter einer Kochplatte (34) angeordnet ist, wobei das magnetische Element (40) über der Kochplatte (34) angeordnet ist, wobei vorzugsweise das Haushaltsgerät (10) ein Induktionskochfeld ist und der Gleichrichter (12) mit einem Leistungsgenerator (16) verbunden ist, der wiederum eine Induktionsspule (26) antreibt.

8. Haushaltsgerät nach Anspruch 6 oder 7,
**dadurch gekennzeichnet, dass**
das magnetische Element (40) auf einer Führungsplatte (42) zwischen der Ein-Position und der Aus-Position geradlinig bewegt werden kann.

9. Haushaltsgerät nach Anspruch 6 oder 7,
**dadurch gekennzeichnet, dass**
die Steuervorrichtung eine drehbare Scheibe (44) umfasst, wobei wenigstens ein magnetisches Element (40) auf der Scheibe (44) angeordnet oder darin eingebettet ist, und wobei das magnetische Element (40) durch Drehen der Scheibe (44) zwischen der Ein-Position und der Aus-Position bewegt werden kann, und wobei vorzugsweise die Scheibe eine kreisförmige Scheibe (44) ist.

10. Haushaltsgerät nach Anspruch 9,
**dadurch gekennzeichnet, dass**
die drehbare Scheibe (44) eine Drehscheibe zum Wählen ist.

11. Haushaltsgerät nach Anspruch 9 oder 10,
**dadurch gekennzeichnet, dass**
die drehbare Scheibe (44) vom Haushaltsgerät (10) abgenommen werden kann und/oder die drehbare Scheibe (44) eine Kindersicherung bereitstellt.

## Revendications

1. Appareil ménager (10) conçu pour un mode veille,
- l'appareil ménager (10) comprenant au moins un commutateur principal (20) commutable entre un état ouvert et un état fermé, l'appareil ménager comprenant en outre une commande d'alimentation par relais (28), au moins un redresseur (12) et au moins un commutateur à lames (32),
- le commutateur principal (20) comportant au moins une entrée haute tension et au moins une sortie haute tension,
- l'entrée haute tension (36) du commutateur principal (20) étant connectable à une ligne secteur (22),
- la sortie haute tension du commutateur principal (20) étant connectée à l'au moins un redresseur (12),
- l'entrée haute tension et la sortie haute tension étant déconnectées galvaniquement l'une de l'autre dans l'état ouvert du commutateur principal (20),
- l'entrée haute tension et la sortie haute tension étant connectées galvaniquement l'une à l'autre dans l'état fermé du commutateur principal (20),
- le commutateur principal (20) étant commandable par au moins un dispositif de commande (40, 42) isolé électriquement de l'appareil ménager (10),
- le commutateur principal étant un relais (20),
- une entrée de commande du commutateur principal (20) étant connectée à la commande d'alimentation par relais (28), la commande d'alimentation par relais (28) étant sensible à l'au moins un commutateur à lames (32), l'au moins un commutateur à lames (32) étant sensible à un champ magnétique généré par le dispositif de commande (40, 42), et
- l'au moins un commutateur à lames (32) étant un commutateur secondaire destiné à commander le commutateur principal (20),
- le redresseur (12) étant adapté à générer au moins une haute tension et à générer au moins une basse tension,
l'appareil ménager étant **caractérisé en ce qu'**il comprend en outre au moins un condensateur, l'au moins un condensateur étant chargeable au cours d'un fonctionnement normal de l'appareil ménager (10), et l'énergie stockée dans ledit condensateur étant adaptée à alimenter la commande d'alimentation par relais (28).

2. Appareil ménager selon la revendication 1, **caractérisé en ce que**
le dispositif de commande (28, 30 ; 40, 42) est une pièce intégrée de l'appareil ménager (10) et/ou une pièce externe (40) correspondant à l'appareil ménager (10).

3. Appareil ménager selon la revendication 1 ou 2, **caractérisé en ce que**
ladite basse tension est fournie pour au moins une alimentation basse tension (24).

4. Appareil ménager selon la revendication 3, **caractérisé en ce que**
l'alimentation basse tension (24) est connectée à une entrée de l'au moins un commutateur à lames (32).

5. Appareil ménager selon la revendication 4, **caractérisé en ce que**
une sortie de l'au moins un commutateur à lames (32) est connectée à la commande d'alimentation par relais (28) .

6. Appareil ménager selon l'une quelconque des revendications précédentes,
**caractérisé en ce que**
le dispositif de commande est un élément magnétique (40) mobile entre au moins une position marche et au moins une position arrêt, le commutateur à lames (32) occupant un état fermé si l'élément magnétique (40) occupe la position marche, tandis que ledit commutateur à lames (32) occupe un état ouvert si l'élément magnétique (40) occupe la position arrêt.

7. Appareil ménager selon la revendication 6, **caractérisé en ce que**
l'appareil ménager (10) est une plaque de cuisson, le commutateur à lames (32) étant agencé en dessous d'un panneau de cuisson (34), tandis que l'élément magnétique (40) est agencé au-dessus dudit panneau de cuisson (34), de préférence l'appareil ménager (10) étant une plaque de cuisson à induction et le redresseur (12) étant connecté à un générateur de puissance (16), qui à son tour commande une bobine d'induction (26).

8. Appareil ménager selon la revendication 6 ou 7, **caractérisé en ce que**
l'élément magnétique (40) est mobile linéairement sur une plaque de guidage (42) entre la position marche et la position arrêt.

9. Appareil ménager selon la revendication 6 ou 7, **caractérisé en ce que**
le dispositif de commande comporte un disque rotatif (44), au moins un élément magnétique (40) étant agencé au niveau dudit disque (44) ou y étant incorporé, et l'élément magnétique (40) étant mobile entre la position marche et la position arrêt par rotation dudit disque (44) et, de préférence, le disque étant un disque circulaire (44).

10. Appareil ménager selon la revendication 9, **caractérisé en ce que**
le disque rotatif (44) est un cadran rotatif.

11. Appareil ménager selon la revendication 9 ou 10, **caractérisé en ce que**
le disque rotatif (44) est détachable de l'appareil ménager (10) et/ou le disque rotatif (44) fournit un dispositif de verrouillage de sécurité pour les enfants.
